Europäisches Patentamt

European Patent Office

Office européen des brevets

(11) Veröffentlichungsnummer: **0 140 455**
**B1**

## EUROPÄISCHE PATENTSCHRIFT

(45) Veröffentlichungstag der Patentschrift: **02.01.91**

(51) Int. Cl.⁵: **G 03 F 1/00**

(21) Anmeldenummer: **84201562.0**

(22) Anmeldetag: **31.10.84**

(54) **Verfahren zur Herstellung einer Maske für die Mustererzeugung in Lackschichten mittels Röntgenstrahllithographie.**

(30) Priorität: **02.11.83 DE 3339624**

(43) Veröffentlichungstag der Anmeldung:
**08.05.85 Patentblatt 85/19**

(45) Bekanntmachung des Hinweises auf die Patenterteilung:
**02.01.91 Patentblatt 91/01**

(84) Benannte Vertragsstaaten:
**DE FR GB NL**

(56) Entgegenhaltungen:
**EP-A-0 104 685**
**DE-A-2 302 116**
**US-A-4 357 417**

**IBM TECHNICAL DISCLOSURE BULLETIN, Band 20, Nr. 7, Dezember 1977, Seiten 2868-2871, New York, US; E.E.CASTELLANI et al.: "Fabrication of E-beam projection and x-ray masks on a support frame"**

(73) Patentinhaber: **Philips Patentverwaltung GmbH Wendenstrasse 35 Postfach 10 51 49 D-2000 Hamburg 1 (DE)**
(84) **DE**

(73) Patentinhaber: **N.V. Philips' Gloeilampenfabrieken Groenewoudseweg 1 NL-5621 BA Eindhoven (NL)**
(84) **FR GB NL**

(72) Erfinder: **Lüthje, Holger Buchenweg 15 D-2083 Halstenbek (DE)**
Erfinder: **Bruns, Angelika Grosse Lohe 31 D-2359 Henstedt-Ulzburg (DE)**
Erfinder: **Harms, Margret Ohmoorring 40 D-2000 Hamburg 62 (DE)**
Erfinder: **Matthiessen, Bernd Bergstrasse 3 D-2105 Seevetal 6 (DE)**

(74) Vertreter: **Nehmzow-David, Fritzi-Maria et al Philips Patentverwaltung GmbH Wendenstrasse 35 Postfach 10 51 49 D-2000 Hamburg 1 (DE)**

# Beschreibung

Verfahren zur Herstellung einer Maske für die Mustererzeugung in Lackschichten mittels Röntgenstrahllithografie mit einer für die Röntgenstrahlung weitgehend transparenten, freitragend auf einem Rahmen befindlichen Membran, auf deren einer Hauptfläche ein die Röntgenstrahlung absorbierendes Muster angebracht wird, wobei die Membran als dünne Schicht aus einem anorganischen Material mittels Kathodenzerstäubung auf einem Substrat angebracht wird und wobei das Substrat anschließend bis auf einen, den Rahmen für die dann freitragende Membran bildenden Teil entfernt wird.

Ein derartiges Verfahren ist aus IBM Technical Disclosure Bulletin 20 (1977), Nr. 7, Dezember, Seiten 2868 bis 2871 bekannt.

Insbesondere bei der Fertigung von integrierten Halbleitersystemen, aber auch z.B. bei der Fertigung von magnetischen Zylinderdomänenanordnungen, besteht eine anhaltende Nachfrage nach immer kleineren Details, und die Auflösung, die heute in der Struktur und in der Maske verlangt wird, nähert sich der Grenze, die durch die Wellenlänge des Lichtes gesetzt ist. Es werden daher bereits andere als lichtoptische Verfahren eingesetzt, um den Übergang zu größerer Auflösung zu ermöglichen.

Besondere Bedeutung kommt im Hinblick auf die Herstellung von kleinsten Mustern im Mikro- und Submikrometerbereich der Röntgenstrahllithografie zu. Bei der Röntgenstrahllithografie handelt es sich im ein 1:1-Projektionsverfahren. Deshalb wird die Genauigkeit der z.B. auf einem Halbleitersubstrat zu erzeugenden Schaltungsmuster im wesentlichen durch die Röntgenmaske bestimmt. Da Röntgenstrahlung in der Materie verhältnismäßig stark absorbiert wird, müssen die Masken aus dünnen Membranen mit darauf präzise angeordneten Absorberstrukturen aufgebaut werden.

Für den Absorber kommen Materialien mit einem möglichst hohen Atomgewicht in Betracht; in der Praxis bewährt haben sich z.B. Gold, Molybdän und Wolfram.

Als Material für die Membran kommen praktisch alle Materialien in Betracht, die hinlänglich transparent für die Röntgenstrahlung sind. Da im Röntgenstrahlbereich jedoch kein Material vollständig transparent und kein Material vollständig opak ist, sollte die Membran relativ dünn sein, um eine möglichst große Transprenz für Röntgenstrahlen zu gewährleisten, das Absorbermuster sollte dagegen relativ dick sein, um eine möglichst hohe Absorbtion von Röntgenstrahlen sicherzustellen. In der Praxis sind u.a. Membranen aus Silicium und aus Titan bekannt. Weiter ist es aus IBM Disclosure Bulletin (a.a.O.) bekannt, als Membranmaterial z.B. Kunststoffe wie Polyimide, Polysulfone oder polyparaxylene einzusetzen. Es hat sich jedoch gezeigt, daß Kunststoffe als Membranmaterial nur bedingt geeignet sind, weil sie nicht ausreichend strahlungsbeständig sind und zum Verziehen neigen und Masken mit derartigen Membranen deshalb eine nur geringe Lebensdauer haben.

Der Erfindung liegt die Aufgabe zugrunde, ein Verfahren der eingangs genannten Art derart zu verbessern, daß es unter Einsparung von Prozeßschritten wirtschaftlich auch für eine Großserienfertigung eingesetzt werden kann und mit dem Masken herstellbar sind, deren Membranen eine hohe Strahlungsbeständigkeit und damit eine relativ lange Lebensdauer aufweisen und auch nach längerem Gebrauch noch verzerrungsfrei sind.

Diese Aufgabe wird erfindungsgemäß dadurch gelöst, daß als Material für die Membran Magnesium eingesetzt wird und daß die Parameter des Kathodenzerstäubungsprozesses derart gewählt werden, daß die Membran unter Zugspannung steht.

Magnesium hat besondere Vorteile als Membranmaterial für Röntgenstrahllithografiemasken, da es eine extrem hohe Durchlässigkeit für Röntgenstrahlung gerade im Bereich zwischen 1 und 4 nm hat. Wegen der im allgemeinen mit zunehmender Wellenlänge steigenden Lackempfindlichkeit einerseits und wegen der gerade noch vertretbaren Beugungserscheinungen andererseits ist insbesondere dieser Wellenlängenbereich für die Röntgenstrahllithografie von besonderem Interesse. Für Röntgenbelichtungsgeräte, die mit einem Kupfertarget arbeiten, ist eine Magnesiummembran besonders geeignet. In derartigen Geräten entsteht CuKα — Strahlung einer Wellenlänge $\lambda = 1,34$ nm. Eine Maske mit einer Magnesiummembran wäre aber auch für Belichtungsgeräte, die mit Synchrotronstrahlung arbeiten, gut geeignet.

Nach einer weiteren vorteilhaften Ausbildung der Erfindung werden auf dem Substrat vor Abscheiden der Membran und auf der Membran Hilfsschichten aus einem für Röntgenstrahlung möglichst transparenten organischen Material angebracht, wobei für die Hilfsschichten insbesondere ein Polyimid eingesetzt wird. Hiermit ist der Vorteil verbunden, daß die Membran geschützt ist, so daß sich weitere Bearbeitungsschritte, z.B. ein galvanischer Prozeß beim Aufbringen der Absorberstruktur, ohne die Membran zu gefährden, ausgeführt werden können.

Ein weiterer Vorteil ist, daß die Hilfsschichten als Teil der Maske beibehalten werden können, da Polyimid hochtransparent für Röntgenstrahlung ist. Durch eine auf diese Weise ausgebildete Verbundmembran werden für eine Maskenanwendung negative Eigenschaften sowohl des Magnesiums als auch des Polyimids kompensiert; Magnesium neigt zu chemischen Oberflächenveränderungen; Kunststoffe, also auch Polyimid, zeigen, abhängig von den Umwelteinflüssen, eine sehr schwankende Maßgenauigkeit und sie altern auch stark unter dem Einfluß von Röntgenstrahlen. Durch die Kombination eines anorganischen und organischer Materialien für die Membran werden diese Nachteile gegenseitig aufgehoben.

Es können durch Ausbildung einer derartigen Verbundmembran relativ große Membranen hergestellt werden, die trotzdem außerordentlich maßgenau arbeiten, auch unter ungünstigen Umgebungsbedingungen und die relativ unempfindlich gegenüber mechanischen und chemischen Angegriffen sind.

Mit der Herstellung der Membran mittels Kathodenzerstäubung ist der Vorteil verbunden, daß die Verfahrensparameter so eingestellt werden können, daß die Schicht unter Zugspannung steht, so daß später, wenn ein Teil des Substrates entfernt ist und eine freitragende Membran vorliegt, Längenänderungen aufgrund thermischer Einflüsse kompensiert werden. Die mechanische Spannung einer durch Kathodenzerstäubung angebrachten Schicht ist durch die Leistung, eine am Substrat liegende Vorspannung und den Gasdruck im Zerstäubungsraum beeinflußbar. Nach vorteilhaften Weiterbildungen der Erfindung wird der Kathodenzerstäubungsprozeß bei einer Leistung im Bereich von 0,4 bis 1,2 W/cm² und einem Gasdruck im Bereich von 10 bis 40μbar durchgeführt, wobei vorzugsweise 0 bis 20% der für den Kathodenzerstäubungsprozeß erforderlichen Leistung dem Plasma über die Substratelektrode in Form einer an der Substratelektrode liegenden Vorspannung zugeführt werden.

Nach einer weiteren vorteilhaften Ausgestaltung der Erfindung wird die Membran zur Herstellung von für Strahlung aus dem sichtbaren Teil des Spektrums transparenten Justierbereichen über eine Abdeckmaske auf das Substrat aufgebracht. Da geeignete Membranmaterialien häufig für den sichtbaren Teil des Spektrums undurchlässig sind, kann die vollautomatische Ausrichtung von Maske und durch sie zu belichtendes Substrat deshalb nicht ohne weiteres mit Hilfe der für diese Prozesse sehr vorteilhaften Laserjustierung erfolgen. Es sind bereits Versuche unternommen worden, in Membranen Justierfenster aus für sichtbares Licht transparentem Material einzusetzen, hierzu ist jedoch eine Vielzahl von zusätzlichen Arbeitsschritten erforderlich, die nach dem vorliegenden Verfahren auf elegante Weise umgangen werden können.

Mit der Erfindung sind außer diesen genannten die weiteren Vorteile verbunden, daß auf überraschend einfache Weise ein sehr funktionstüchtiger Maskenträger für eine Röntgenstrahllithographiemaske hergestellt werden kann, dessen Membran ohne manuelle prozeßschritte wie Ablösen von einem Substrat, Spannen und Aufkleben auf einen gesonderten Rahmen direkt auf einem Substrat in einer einstellbaren gewünschten mechanischen Vorspannung erzeugt werden kann, wobei auch kein gesonderter Rahmen mehr angefertigt zu werden braucht, weil der erforderliche Rahmen direkt aus dem Substrat gebildet werden kann, wobei der Herstellungsprozeß für die Membran auch noch gleichzeitig die Ausbildung von Justierfenstern gestattet.

Überraschend ist bei demVerfahren nach der vorliegenden Erfindung, das besonders wirtschaftlich und daher für eine Großserienfertigung gut geeignet ist, daß das verhältnismäßig dicke Substrat in dem Teil, in dem die Membran später freitragend sein soll, leicht entfernt werden kann ohne die vorher erzeugten Spannungsverhältnisse in der Membran nachteilig zu beeinflussen.

Anhand der Zeichnung wird ein Ausführungsbeispiel der Erfindung beschrieben und in seiner Wirkungsweise erläutert.

Es zeigen

Fig. 1 Substrat mit Mehrschichtmembran im Schnitt

Fig. 2a, 2b Membran mit Justierfenstern im Schnitt (Fig. 2a) und in Draufsicht (Fig. 2b)

Fig. 3a, 3b Graphische Darstellung der in einer mittels Kathodenzerstäubung auf ein Substrat aufgebrachten Magnesiumschicht über unterschiedliche Prozeßparameter erzeugten Spannung

Fig. 4a, 4b Mehrschichtmembran im Schnitt; Darstellung von Prozeßschritten zur teilweisen Entfernung des Substrates.

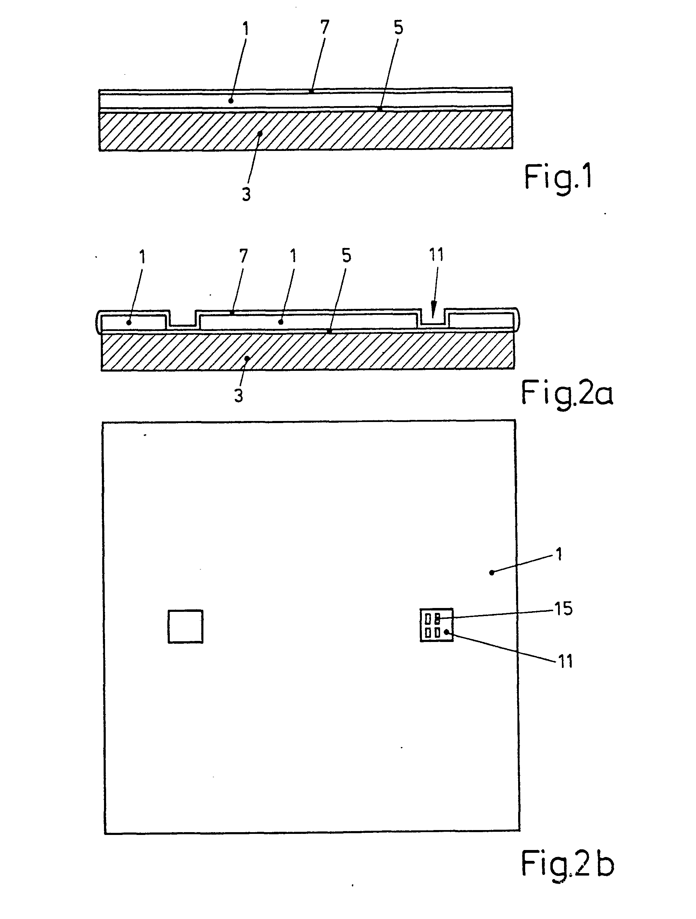

In Fig. 1 ist eine Membran 1 gemäß der Erfindung auf einem Substrat 3 im Schnitt gezeigt, wobei Hilfsschichten 5 und 7 zwischen dem Substrat 3 und der Membran 1 und oberhalb der Membran 1 angebracht wurden.

Im vorliegenden Beispiel wird die Herstellung einer Magnesium-Membran auf einem Glassubstrat beschrieben, wobei die Magnesium-Membran durch Hilfsschichten aus Polyimid geschützt ist.

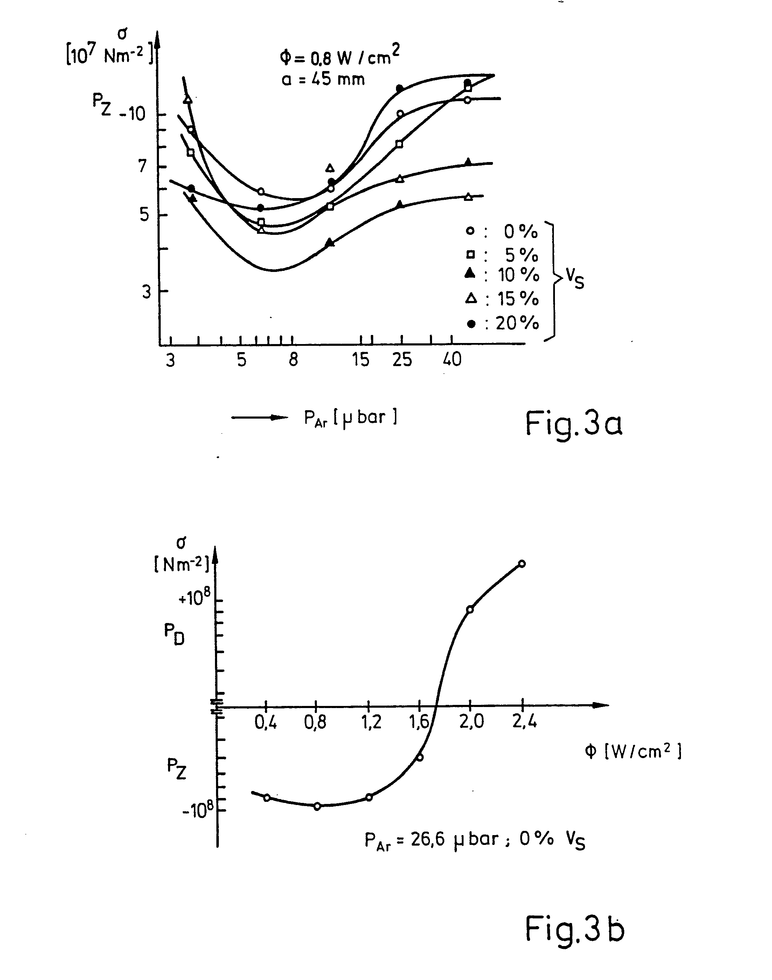

Als Substrat 3 wird einehandelsübliche Glasplatte mit z.B. 4" Standardabmessungen auf einer Seite mit einem Sandwichaufbau, bestehend aus zwei je 0,5μm dicken Hilfsschichten 5, 7 aus Polyimid und einer dazwischenliegenden Magnesium-Membran 1 in Form einer 2μm dicken Magnesiumschicht beschichtet. Zur Herstellung der Polyimidschicht 5 kann ein kommerziell erhältlicher Lack verwendet werden, der aufgeschleudert und einem anschließenden Imidisierungsprozeß unterworfen wird. Günstige Ergebnisse werden erreicht bei folgender Temperaturbehandlung, vorzugsweise in N₂-Atmosphäre:eine Stunde Tempern bei 100°C, eine Stunde Tempern bei 180°C und eine Stunde Tempern bei 350°C. Anschließend wird die Membran 1 in Form einer Magnesiumschicht mit Hilfe von Kathodenzerstäubung aufgebracht. Dabei ist es von besonderer Bedeutung, daß die Schicht mit einer Zugspannung erzeugt wird, so daß thermische Längenänderungen kompensiert werden können.Die gewünschte Zugspannung kann durch Anwendung bestimmter Kathodenzerstäubungsparameter eingestellt werden. Wie in Figur 3a und 3b dargestellt ist, kann die mechanische Spannung in Magnesiumschichten durch die Leistung, die Substratvorspannung und den Gasdruck im Zerstäubungsraum beeinflußt werden.

In Fig. 3a ist die in einer Magnesiumschicht bei einer Leistung von 0,8W/cm² und einem Elektrodenabstand a = 45mm erzeugte Zugspannung gegen den Argondruck in der Zerstäubungskammer unter unterschiedlichen Vorspannungen am Substrat aufgetragen.

In Fig. 3b ist die in einer Magnesiumschicht bei einem Argondruck von 26,6µbar und 0% Vorspannung am Substrat erzeugte Spannung gegen die Leistung aufgetragen.

Optimale Bedingungen für das hier beschriebene Ausführungsbeispiel konnten bei einer Leistung von 0,4W/cm², einem Argondruck von 20µbar und 0% Vorspannung am Substrat erreicht werden.

Ein erheblicher Vorteil des vorliegenden Verfahrens ist, daß zur Herstellung von optisch transparenten Justierbereichen 11 eine einfache mechanische Abdeckmaske während des Aufstäubens der Membran 1 angewendet werden kann (vergleiche Figuren 2a, 2b). In späteren Arbeitsschritten mit Hilfe von Elektronenstrahllithographie erzeugte Justierfiguren können von den transparenten Hilfsachichten 5, 7 aus Polyimid getragen werden.

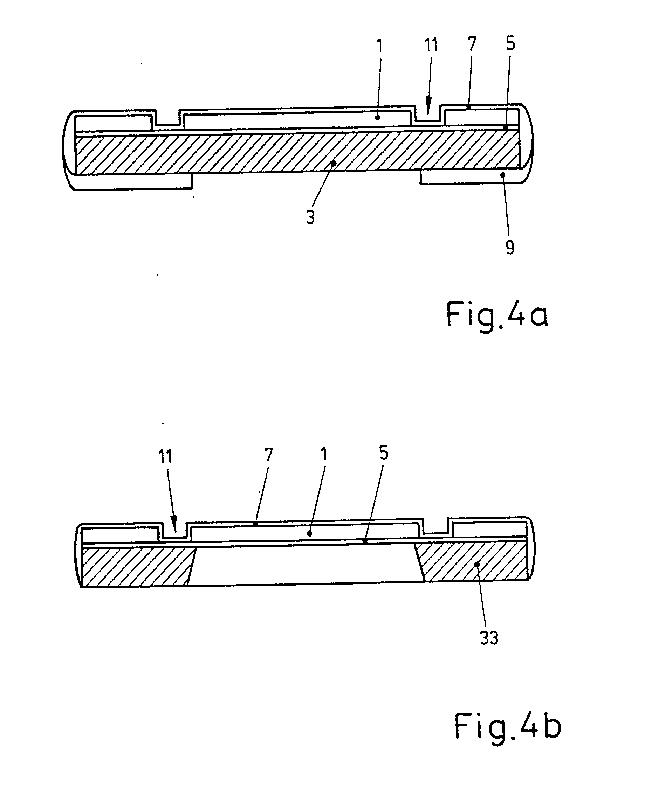

Zur Bildung einer Mehrschichtmembran wird auf die Membran 1 anschließend die Hilfsschicht 7 aus Polyimid aufgebracht. Diese Schicht wird ebenfalls aufgeschleudert. Die Temperbehandlung für diese Hilfsschicht erfolgt vorteilhafterweise bei einer Temperatur von 150°C über eine Dauer von 4 Stunden. Die Festlegung der Membranfläche kann reproduzierbar mit Hilfe einer photolithographisch erzeugten Maske oder mit Hilfe einer mechanischen Verkapselung und eines Ätzprozesses erfolgen. Wird mit einer photolithographisch erzeugten Maske gearbeitet, wird die Rückseite des Substrates 3 aus Glas mit einer 2µm dicken Photolackschicht 9 belackt und bei 90°C über die Dauer von einer Stunde getempert. Entsprechend der gewünschten Fläche und Form der Membran wird diese Photolackschicht mit einer Maske belichtet und entwickelt (Figur 4a). Mit Hilfe eines naßchemischen Ätzprozesses wird das Substrat 3 aus Glas in dem nicht mit Photolack 9 bedeckten Bereich entfernt, wobei die Ätzung an der Hilfsschicht 5 aus Polyimid stoppt. Als Ätzmittel kann ein Gemisch aus Fluorwasserstoffsäure HF jund $H_2O$ verwendet werden.

Statt eines naßchemischen Ätzprozesses ist auch ein Plasmaätzprozeß oder die Kombination eines naßchemischen Ätzprozesses mit einem Trockenätzprozeß mit Erfolg einsetzbar.

Wird der Verbundkörper aus Substrat 3, Membran 1 und Hilfsschichten 5, 7 mit Hilfe einer mechanischen Verkapselung geätzt, kann die Größe der freitragenden Membranfläche festgelegt werden über ein, in seiner Größe der Größe der gewünschten Membranfläche entsprechendes Fenster in der Verkapselung.

Das Substrat 3 ist in den Figuren 1, 2a, 4a und 4b als monolithischer Körper dargestellt, aus welchem der nicht den Rahmen 33 bildende Teil durch Ätzen entfernt wird. Es ist nun mit Vorteil auch folgendes Vorgehen möglich: Ein Rahmen mit einer der Größe der freitragenden Membran entsprechenden Öffnung wird einseitig mit einem durchgehenden, jedoch dünneren Substrat kraftschlüssig verbunden, z.B. durch Verkleben, so daß bei dem anschließenden Ätzprozeß nur noch ein Substratteil mit geringer Dicke im Bereich der Öffnung des Rahmens geätzt zu werden braucht, wodurch trotzdem ein stabiler Rahmen großer Dicke erzeugt wird.

Der auf diese Weise hergestellte Maskenträger (Fig. 4b) mit einer Membran 1 und zwei Hilfsschichten 5, 7 auf einem aus dem Substrat 3 herausgeätzten Rahmen 33 wird anschließend auf bekannte Weise mit den gewünschten Absorbermustern versehen, wobei die auf der Membran 1 verbleibenden dünnen Hilfsschichten 5, 7 aus Polyimid die vorteilhafte Herstellung von galvanisch verstärkten Absorberstrukturen ermöglichen.

Eine vorteilhafte Ausführung einer mit Licht justierbaren Maske wird erhalten, wenn z.B. bei der Herstellung von Halbleiterbauelementen für einen ersten Maskenschritt erforderliche Justierfiguren, vergleiche Figur 2b, Justierfiguren (15) mit Hilfe von Elektronenstrahllithographie auf dem Substrat 3 innerhalb der Justierfenster 11 ausgebildet werden, während als Figuren für einen weiteren Maskenschritt auf der Membran 1 zusätzlich außerhalb des Rahmenbereiches erzeugte Justierfiguren dienen können. Auf diese Weise ergeben sich Wechselfiguren für einen Stepund Repeat-Betrieb. Die Periodizität richtet sich dabeinach der abzubildenden Step- und Repeat-Feldgröße.

## Patentansprüche

1. Verfahren zur Herstellung einer Maske für die Mustererzeugung in Lackschichten mittels Röntgenstrahllithografie mit einer für die Röntgenstrahlung weitgehend transparenten, freitragend auf einem Rahmen befindlichen Membran, auf deren einer Hauptfläche ein die Röntgenstrahlung absorbierendes Muster angebracht wird, wobei die Membran als dünne Schicht aus einem anorganischen Material mittels Kathodenzerstäubung auf einem Substrat angebracht wird und wobei das Substrat anschließend bis auf einen, den Rahmen für die dann freitragende Membran bildenden Teil entfernt wird, dadurch gekennzeichnet, daß als Material für die Membran (1) Magnesium eingesetzt wird und daß die Parameter des Kathodenzerstäubungsprozesses derart gewählt werden, daß die Membran unter Zugspannung steht.

2. Verfahren nach Anspruch 1, dadurch gekennzeichnet, daß der Kathodenzerstäubungsprozeß bei einer Leistung im Bereich von 0,4 bis 1,2 W/cm² und einem Gasdruck im Bereich von 10 bis 40 µbar durchgeführt wird.

3. Verfahren nach Anspruch 2, dadurch gekennzeichnet, daß 0 bis 20% der für den Kathodenzerstäubungsprozeß erforderlichen Leistung dem Plasma in Form einer an der Substratelektrode liegenden Vorspannung zugeführt werden.

4. Verfahren nach Anspruch 1, dadurch gekennzeichnet, daß auf dem Substrat (3) vor Abscheiden der Membran (1) und auf der Membran Hilfsschichten (5, 7) aus einem für die Röntgenstrahlung möglichst transparenten organischen Material angebracht werden.

5. Verfahren nach Anspruch 4, dadurch gekennzeichnet, daß als Material für die Hilfsschichten (5, 7) ein Polyimid eingesetzt wird.

6. Verfahren nach Anspruch 1, dadurch gekennzeichnet, daß die Membran (1) zur Herstellung von für Strahlung aus dem sichtbaren Teil des Spektrums transparenten Justierbereichen (11) über eine Abdeckmaske, die die Justierbereiche abdeckt, auf das Substrat (3) aufgebracht wird.

7. Verfahren nach Anspruch 1, dadurch gekennzeichnet, daß als Material für das Substrat (3) Glas eingesetzt wird.

8. Verfahren nach Anspruch 7, dadurch gekennzeichnet, daß der nicht den Rahmen (33) bildende Teil des Substrates (3) durch einen naßchemischen Ätzprozeß entfernt wird.

## Revendications

1. Procédé de fabrication d'un masque pour la formation de configurations dans des couches de laque par lithographie aux rayons X, muni d'une membrane très transparente aux rayons X et située en porte-à-faux sur un cadre, membrane sur une surface principale de laquelle est formée une configuration absorbant les rayons X, suivant lequel, à partir d'un matériau inorganique, la membrane est déposée par pulvérisation cathodique comme couche mince sur un substrat et suivant lequel, ensuite, le substrat est éliminé jusqu'à une partie formant le cadre pour la membrane qui est alors en porte-à-faux, caractérisé en ce que comme matériau pour la membrane (1), on utilise du magnésium et en ce que le paramètre du processus de pulvérisation cathodique est choisi de façon que la membrane soit soumise à une contrainte de traction.

2. Procédé selon la revendication 1, caractérisé en ce que le processus de pulvérisation cathodique est effectué à une puissance comprise entre 0,4 et 1,2 W/cm$^2$ et à une pression gazeuse comprise entre 10 et 10 µbars.

3. Procédé selon la revendication 2, caractérisé en ce que 0 à 20% de la puissance nécessaire pour le processus de pulvérisation cathodique est fourni au plasma sous la forme d'une tension de polarisation appliquée à l'électrode de substrat.

4. Procédé selon la revendication 1, caractérisé en ce que sur le substrat (3), avant le dépôt de la membrane (1), et sur la membrane, on forme des couches auxiliaires (5, 7) en matériau organique le plus transparent possible aux rayons X.

5. Procédé selon la revendication 4, caractérisé en ce que, comme matériau des couches auxiliaires (5, 7), on utilise un polyimide.

6. Procédé selon la revendication 1, caractérisé en ce que, pour réaliser des zones d'ajustement (11) transparentes au rayonnement de la partie visible du spectre, la membrane (1) est formée sur le substrat (3) à travers un masque de recouvrement recouvrant les zones d'ajustement.

7. Procédé selon la revendication 1, caractérisé en ce que, comme matériau du substrat (3), on utilise du verre.

8. Procédé selon la revendication 7, caractérisé en ce que la partie du substrat (3) qui ne forme pas le cadre (33) est éliminée par un processus d'attache chimique humide.

## Claims

1. A method of manufacturing a mask for producing patterns in lacquer layers by means of X-ray lithography, comprising a diaphragm which is very transparent to the X-ray radiation, is present in a self-supporting manner on a frame and on one major surface of which a pattern absorbing the X-ray radiation is provided, the diaphragm being applied to a substrate as a thin layer of an inorganic material by means of cathode sputtering and the substrate being subsequently removed, except for a part constituting the frame for the then self-supporting diaphragm, characterized in that the material used for the diaphragm (1) is magnesium and in that the parameters of the cathode sputtering process are chosen to be such that the diaphragm is subjected to tensile stress.

2. A method as claimed in Claim 1, characterized in that the cathode sputtering process is carried out at a power in the range of from 0.4 to 1.2 W/cm$^2$ and at a gas pressure in the range of from 10 to 40 µbar.

3. A method as claimed in Claim 2, characterized in that 0 to 20% of the power required for the cathode sputtering process is supplied to the plasma in the form of a bias voltage applied to the substrate electrode.

4. A method as claimed in Claim 1, characterized in that auxiliary layers (5, 7) of an organic material as transparent as possible to the X-ray radiation are applied to the substrate (3) before deposition of the diaphragm (1) and to the diaphragm.

5. A method as claimed in Claim 4, characterized in that the material used for the auxiliary layers (5, 7) is a polyimide.

6. A method as claimed in Claim 1, characterized in that the diaphragm (1) is applied to the substrate (3) for obtaining adjustment areas (11) transparent to radiation from the visible part of the spectrum through a covering mask covering the adjustment areas.

7. A method as claimed in Claim 1, chaacterized in that the material used for the substrate (3) is glass.

8. A method as claimed in Claim 7, characterized in that the part of the substrate (3) not constituting the frame (33) is removed by a wet-chemical etching process.

Fig.1

Fig.2a

Fig.2b

Fig.3a

Fig.3b

Fig.4a

Fig.4b